# EUROPEAN PATENT APPLICATION

(11) **EP 4 415 025 A1**
(43) Date of publication of application: **14.08.2024**
(21) Application number: 22878362.7
(22) Date of filing: 26.09.2022
(51) Int. Cl.: H01L 21/205, C30B 29/36

(54) **METHOD FOR IMPROVIING DOPANT ACTIVATION RATE AND STRUCTURE CREATED BY MEANS OF SAID METHOD**

(30) Priority: 05.10.2021 JP 2021164359
(71) Applicant: Kwansei Gakuin Educational Foundation, Nishinomiya-shi, Hyogo 662-8501 (JP); Toyota Tsusho Corporation, Nagoya-shi Aichi 450-8575 (JP)
(72) Inventor: KANEKO, Tadaaki, Sanda-shi, Hyogo 669-1337 (JP); KOJIMA, Kiyoshi, Tokyo 108-8208 (JP)
(74) Representative: Schön, Christoph
(86) International application number: PCT/JP2022/035761
(87) International publication number: WO 2023/058492

(57) **Abstract**

An object of the present invention is to provide a novel technique for improving an activation rate of dopant of an epitaxial layer. Another object of the present invention is to provide a novel technique for suppressing variation in activation rate of dopant in the epitaxial layer.

The present invention is a method for improving the activation rate of dopant of an epitaxial layer 20, including a growth step S10 of growing the epitaxial layer 20 having the dopant on a bulk layer 10 under an equilibrium vapor pressure environment.

## Description

### Technical Field

The present invention relates to a method for improving an activation rate of dopant and a structure prepared by the method.

### Background Art

As a next-generation semiconductor material replacing silicon (Si), compound semiconductors such as silicon carbide (SiC), gallium nitride (GaN), and gallium oxide (Ga₂O₃) have attracted attention.

For example, the silicon carbide has a dielectric breakdown electric field that is one order of magnitude larger than that of silicon, a band gap that is three times larger than that of silicon, and a thermal conductivity that is about three times higher than that of silicon. Therefore, the silicon carbide is expected to be applied to power devices, high frequency devices, high temperature operation devices, and the like.

In order to realize ultra-high withstand voltage and low loss in a semiconductor device (a device), it is necessary to appropriately control impurity (dopant) concentration of an epitaxial layer. In view of such a problem, various methods of epitaxial growth for controlling the impurity concentration have been proposed.

For example, Patent Literature 1 describes a technique of "A method of manufacturing a silicon carbide semiconductor substrate, the method comprising: a step of supplying a hydrogen-containing gas into an epitaxial growth device and heating an inside of the epitaxial growth device for a predetermined period of time; and a step of transporting a single crystal silicon carbide substrate into the epitaxial growth device and supplying a dopant gas containing a source gas, a carrier gas, and an impurity for determining a conductivity type to form a film of single crystal silicon carbide on the single crystal silicon carbide substrate by epitaxial growth."

Meanwhile, the inventors of the present application have developed a growth method different from the thermal CVD method and filed patent applications. For example, Patent Literature 2 describes a technique for growing an epitaxial layer of silicon carbide under a SiC-C equilibrium vapor pressure environment. Patent Literature 3 describes a technique for growing the epitaxial layer of silicon carbide under the SiC-Si equilibrium vapor pressure environment.

### Citation List

### Patent Literature

Patent Literature 1: JP 2019-121690 A
Patent Literature 2: WO 2020/095872 A
Patent Literature 3: WO 2020/095873 A

### Summary of Invention

### Technical Problem

In order to reduce on-resistance of the semiconductor device, it is desirable to improve the activation rate of dopant of the epitaxial layer.

One of the causes for increasing the on-resistance is variation in activation rate of dopant. For example, in a case where the activation rate of dopant in the epitaxial layer is locally low, it causes variations in threshold voltage and on-resistance of the semiconductor device. Furthermore, the variations in threshold voltage and on-resistance may cause not only a decrease in energization capacity but also current concentration at a specific location, which may cause breakdown.

An object of the present invention is to provide a novel technique for improving the activation rate of dopant of the epitaxial layer.

Another object of the present invention is to provide a novel technique for suppressing the variation in activation rate of dopant in the epitaxial layer.

### Solution to Problem

The present invention for solving the above-described problems is a method for improving an activation rate of dopant of an epitaxial layer, the method including a growth step of growing the epitaxial layer on a bulk layer under an equilibrium vapor pressure environment.

In a preferred mode of the present invention, the growth step is a step of growing the epitaxial layer having a higher activation rate of dopant than that of the bulk layer.

In a preferred mode of the present invention, the growth step is a step of crystal-growing an epitaxial layer in which the activation rate of dopant is 33% or more.

In a preferred mode of the present invention, a quantification step of quantifying an activation rate of dopant of the epitaxial layer is included.

In a preferred mode of the present invention, the quantification step includes a first measurement step of measuring a concentration of a dopant of the epitaxial layer, a second measurement step of measuring a carrier concentration of the epitaxial layer, and a calculation step of calculating an activation rate of dopant of the epitaxial layer based on measurement results of the first measurement step and the second measurement step.

In a preferred mode of the present invention, the growth step is a step of growing the epitaxial layer on a bulk layer having a diameter of at least 4 inches or more.

The present invention also relates to a method of manufacturing a semiconductor substrate. In other words, the present invention for solving the above-described problems is a method of manufacturing a semiconductor substrate including a growth step of growing an epitaxial layer on a bulk layer under an equilibrium vapor pressure environment.

The present invention also relates to a semiconductor substrate. In other words, the present invention for solving the above-described problem is a semiconductor substrate including an epitaxial layer grown on a bulk layer, in which the epitaxial layer has a higher activation rate of dopant than that of the bulk layer.

In a preferred mode of the present invention, the epitaxial layer has the activation rate of dopant of 33% or more.

In a preferred mode of the present invention, it has a diameter of at least 4 inches or more.

The present invention also relates to a method of manufacturing a semiconductor device. In other words, the present invention for solving the above-described problems is a method of manufacturing the semiconductor device including a growth step of growing an epitaxial layer on a bulk layer under an equilibrium vapor pressure environment, and a device formation step of forming a device region on at least a part of a substrate obtained by the growth step.

In a preferred mode of the present invention, the method further includes a removal step of removing at least a part of the bulk layer.

The present invention also relates to a semiconductor device. In other words, the present invention for solving the above-described problem is a semiconductor device including the epitaxial layer having a higher activation rate of dopant than that of the bulk layer.

In a preferred mode of the present invention, the epitaxial layer has the activation rate of dopant of 33% or more.

### Advantageous Effects of Invention

According to the disclosed technique, it is possible to provide a novel technique for improving the activation rate of dopant of the epitaxial layer.

According to the disclosed technique, it is possible to provide a novel technique for suppressing the variation in activation rate of dopant of the epitaxial layer.

Other problems, features and advantages will become apparent from a reading of the following detailed description when taken in conjunction with the drawings and claims.

### Brief Description of Drawings

Fig. 1 is an explanatory view for explaining a method for improving an activation rate of dopant of an epitaxial layer according to an embodiment.
Fig. 2 is an explanatory view for explaining the method for improving the activation rate of dopant of the epitaxial layer according to the embodiment.
Fig. 3 is an explanatory view for explaining the method for improving the activation rate of dopant of the epitaxial layer according to the embodiment.
Fig. 4 is an explanatory view for explaining the method for measuring a carrier concentration of the epitaxial layer according to the embodiment.
Fig. 5 is an explanatory view for explaining a method for improving the activation rate of dopant of an epitaxial layer according to another embodiment.
Fig. 6 is an explanatory view for explaining a method of manufacturing a semiconductor device according to an embodiment.
Fig. 7 is an explanatory view for explaining a method of manufacturing a semiconductor device according to another embodiment.

### Description of Embodiments

Hereinafter, preferred embodiments of a method for improving an activation rate of dopant of an epitaxial layer according to the present invention and a structure prepared by the method will be described in detail with reference to the accompanying drawings. A technical scope of the present invention is not limited to the embodiments illustrated in the accompanying drawings, and can be appropriately changed within the scope described in the claims. In the present description and the accompanying drawings, in a layer or a region denoted with n or p, it means that electrons or holes are majority carriers, respectively. + and - added to n and p mean a higher impurity concentration and a lower impurity concentration than a layer and a region to which n and p are not added, respectively. In a case where notations of n and p including + and - are the same, it indicates that concentrations are close, and the concentrations are not necessarily equal. In the present description, in the notation of the Miller indices, "-" means a bar attached to an index immediately after the index, and "-" is added in front of the index to express a negative index. In the following description of the embodiment and the accompanying drawings, the same reference numerals are given to the same configurations, and redundant description is omitted.

### <<Method for improving activation rate of dopant in epitaxial layer>>

The method for improving the activation rate of dopant of the epitaxial layer according to the present invention may include a growth step S10 of growing the epitaxial layer 20 having the dopant on the bulk layer 10 under an equilibrium vapor pressure environment, and a quantification step S20 of quantifying the activation rate of dopant of the epitaxial layer 20.

The present invention can improve the activation rate of dopant of the epitaxial layer 20 by including the growth step S10 of growing the epitaxial layer 20 under the equilibrium vapor pressure environment. Variations in the activation rate of dopant of the epitaxial layer 20 can be suppressed.

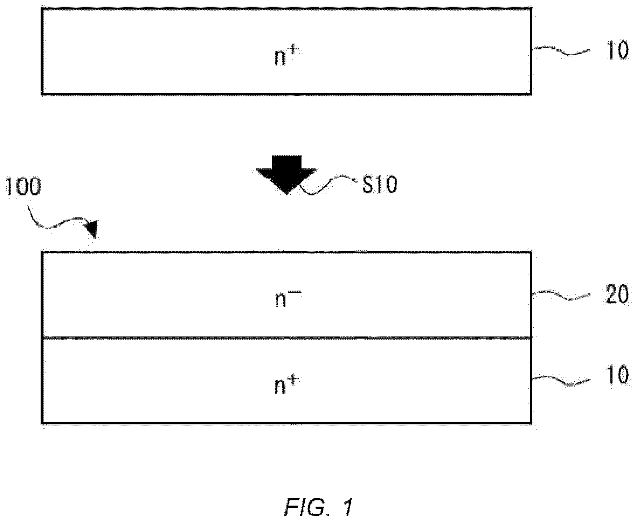

Fig. 1 is the explanatory view for explaining the embodiment of the method for improving the activation rate of dopant of the epitaxial layer. The method for improving the activation rate of dopant of the epitaxial layer according to the present embodiment includes the growth step S10 of growing an n⁻ type epitaxial layer 20 having a concentration of dopant (a doping concentration) lower than that of the n⁺ type bulk layer 10 on the n⁺ type bulk layer 10 of a compound semiconductor under the equilibrium vapor pressure environment.

### <Growth step S10>

Hereinafter, growth conditions of the growth step S10 according to the present invention will be described in detail.

### (Equilibrium vapor pressure environment)

The "equilibrium vapor pressure environment" in the present description refers to an environment of vapor pressure when a material of the bulk layer 10 and a source of the epitaxial layer 20 are in a phase equilibrium state via a gas phase.

Hereinafter, the growth step S10 for growing the epitaxial layer 20 of silicon carbide will be described in detail as an example.

An "equilibrium vapor pressure environment" in which the epitaxial layer 20 of silicon carbide is grown includes an "SiC-C equilibrium vapor pressure environment" and an "SiC-Si equilibrium vapor pressure environment".

The "SiC-C equilibrium vapor pressure environment" in the present description refers to an environment of vapor pressure when SiC (solid phase) and C (solid phase) are in the phase equilibrium state via the gas phase. This SiC-C equilibrium vapor pressure environment can be formed by heat treating a quasi-closed space having an atomic ratio Si/C of 1 or less. For example, the manufacturing apparatus and the growth conditions described in Patent Literature 2 can be adopted.

Specifically, when the SiC substrate satisfying a stoichiometric ratio 1 : 1 is disposed in a SiC container satisfying the stoichiometric ratio 1 : 1, the atomic number ratio Si/C in the container is 1. A C vapor supply source (a C pellet or the like) may be disposed to set the atomic number ratio Si/C to 1 or less. By heating the container disposed so that the atomic ratio Si/C in the container is 1 or less in this manner, the SiC-C equilibrium vapor pressure environment can be formed in the container.

The "SiC-Si equilibrium vapor pressure environment" in the present description refers to an environment of vapor pressure when SiC (solid phase) and Si (liquid phase) are in the phase equilibrium state via the gas phase. This SiC-Si equilibrium vapor pressure environment can be formed by heat treating a quasi-closed space in which the atomic ratio Si/C exceeds 1. For example, the manufacturing apparatus and the growth conditions described in Patent Literature 3 can be adopted.

Specifically, when a SiC substrate satisfying the stoichiometric ratio 1 : 1 and a Si vapor supply source (a Si pellet or the like) are disposed in a SiC container satisfying the stoichiometric ratio 1 : 1, the atomic ratio Si/C in the container exceeds 1. The SiC-Si equilibrium vapor pressure environment can be formed in the container by heating the container arranged such that the atomic ratio Si/C in the container exceeds 1 in this manner.

The SiC-C equilibrium vapor pressure environment and the SiC-Si equilibrium vapor pressure environment in the present description include a near-thermal equilibrium vapor pressure environment that satisfies a relationship between a growth rate and a growth temperature derived from a theoretical thermal equilibrium environment.

The "quasi-closed space" in the present description refers to a space in which inside of the container can be evacuated but at least a part of vapor generated in the container can be confined. This quasi-closed space can be formed in the container.

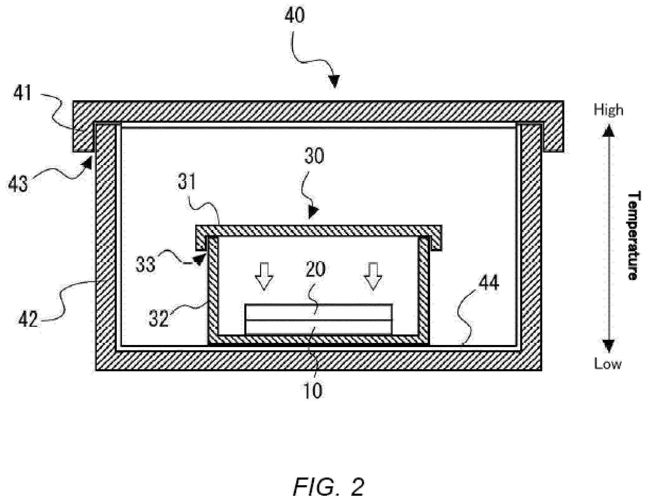

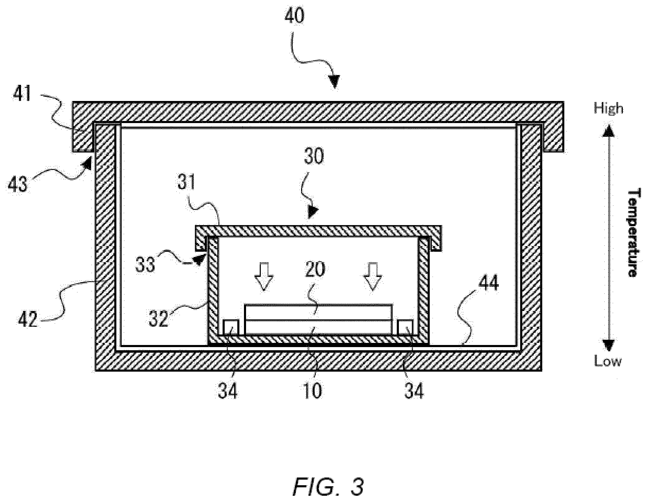

Figs. 2 and 3 are explanatory views for explaining how the epitaxial layer 20 is grown using the manufacturing apparatus adopted in the method for growing silicon carbide according to the embodiment. A manufacturing apparatus that realizes the equilibrium vapor pressure environment includes a main container 30 that accommodates a base substrate (the bulk layer 10) and a refractory material container 40 that accommodates the main container 30.

In a state where the base substrate (the bulk layer 10) is accommodated in the main container 30 and the main container 30 is accommodated in the refractory material container 40, by heating with a temperature gradient so that the temperature of a base substrate side becomes low, atoms are supplied from a part of the main container 30 on a high temperature side to the base substrate, and the epitaxial layer 20 is formed.

Fig. 2 is the explanatory view for explaining the formation of the SiC-C equilibrium vapor pressure environment with the atomic ratio Si/C in the main container 30 set to 1 or less. Fig. 3 is the explanatory view for explaining the formation of the SiC-Si equilibrium vapor pressure environment such that the atomic ratio Si/C in the main container 30 exceeds 1.

### (Bulk layer 10)

As the semiconductor material of the bulk layer 10, any generally used compound semiconductor material can be adopted. As an example, the silicon carbide (SiC) will be described in detail, but other known group IV-IV compound semiconductor materials may be adopted. As the semiconductor material, a known group II-VI compound semiconductor material such as zinc oxide (ZnO), zinc sulfide (ZnS), zinc selenide (ZnSe), cadmium sulfide (CdS), or cadmium telluride (CdTe) may be adopted. As the semiconductor material, for example, a known group III-V compound semiconductor material such as boron nitride (BN), gallium arsenide (GaAs), gallium nitride (GaN), aluminum nitride (AlN), indium nitride (InN), gallium phosphide (GaP), indium phosphide (InP), or indium antimonide (InSb) may be adopted. As the semiconductor material, for example, an oxide semiconductor material such as aluminum oxide (Al₂O₃) or gallium oxide (Ga₂O₃) may be adopted. Note that the bulk layer 10 may have a configuration in which known added atoms used according to the material are appropriately added.

The bulk layer 10 includes a wafer obtained by slicing an ingot prepared by a sublimation method or the like into a disk shape, or a substrate obtained by processing a single crystal of a compound semiconductor into a thin plate shape. As the single crystal polymorph of the compound semiconductor, any polytype can be adopted.

The dopant added to the bulk layer 10 may be an element doped in a general semiconductor material. Specifically, nitrogen (N), phosphorus (P), aluminum (Al), boron (B), and the like can be exemplified. In the embodiment, nitrogen or phosphorus in which the bulk layer 10 is n-type is employed, but aluminum or boron in which the bulk layer 10 is p-type may be employed.

The concentration of dopant of the bulk layer 10 is preferably higher than 1 × 10¹⁷ cm⁻³, more preferably 1 × 10¹⁸ cm⁻³ or more, and still more preferably 1 × 10¹⁹ cm⁻³ or more.

A diameter of the bulk layer 10 is preferably 4 inches or more, more preferably 6 inches or more, and still more preferably 8 inches or more.

### (Epitaxial layer 20)

The epitaxial layer 20 is a layer having a higher activation rate of dopant than that of the bulk layer 10.

The activation rate of dopant of the epitaxial layer 20 is preferably 33% or more, more preferably 40% or more, further preferably 50% or more, further preferably 60% or more, further preferably 66% or more, further preferably 70% or more, further preferably 80% or more, and still further preferably 90% or more.

In the epitaxial layer 20, it is preferable that the variation in activation rate of dopant is suppressed. Specifically, a standard deviation of the carrier concentration measured at a plurality of points in a plane of the epitaxial layer 20 is preferably 1.0 × 10¹⁷ cm⁻³ or less, more preferably 5.0 × 10¹⁶ cm⁻³ or less, further preferably 3.0 × 10¹⁶ cm⁻³ or less, further preferably 2.0 × 10¹⁶ cm⁻³ or less, further preferably 1.0 × 10¹⁶ cm⁻³ or less, further preferably 5.0 × 10¹⁵ cm⁻³ or less, and still further preferably 3.0 × 10¹⁵ cm⁻³ or less.

A value of a variation coefficient (standard deviation/average value) of the carrier concentration in the plane of the epitaxial layer 20 is preferably 0.05 or less, more preferably 0.04 or less, more preferably 0.04 or less, more preferably 0.02 or less, and still more preferably 0.01 or less. As described above, since the variation in carrier concentration is suppressed to be extremely small, it is suggested that the variation in activation rate of dopant is suppressed.

The material of the epitaxial layer 20 may employ any material that can be epitaxially grown as a material of the compound semiconductor generally in addition to the silicon carbide. For example, the material of epitaxial layer 20 may be a known material that may be employed as the material of the bulk layer 10 described above, or may be a known material that may be epitaxially grown on the bulk layer 10.

Specifically, as the material of the epitaxial layer 20, for example, GaN, AlN, InN, ZnS, ZnSe, CdTe, GaP, GaAs, InP, InAs, InSb, or the like can be adopted. A combination of the material of the bulk layer 10 and the material of the epitaxial layer 20 can be appropriately selected in consideration of a difference in a lattice constant and a thermal expansion coefficient between both materials.

The concentration of dopant of the epitaxial layer 20 is preferably lower than 1 × 10¹⁷ cm⁻³, more preferably 1 × 10¹⁶ cm⁻³ or less, and still more preferably 1 × 10¹⁵ cm⁻³ or less.

### (Main container 30)

The main container 30 can accommodate the base substrate (the bulk layer 10), and is configured to generate vapor pressure of a vapor phase species containing an element of a semiconductor material to be grown therein. For example, when the epitaxial layer 20 of silicon carbide is grown, a vapor pressure of a vapor phase species containing a Si element and a vapor phase species containing a C element may be generated in an internal space during heat treatment. For example, the main container 30 is made of a material containing polycrystalline SiC. In the embodiment, the entire main container 30 is made of the polycrystalline SiC. By heating the main container 30 made of such a material, vapor pressures of a gas phase type containing the Si element and a gas phase type containing the C element can be generated.

In other words, it is desirable that an environment in the heat-treated main container 30 be a vapor pressure environment of a mixed system of a gas phase type containing the Si element and a gas phase type containing the C element. Examples of the gas phase type containing the Si element include Si, Si₂, Si₃, Si₂C, SiC₂, and SiC. Examples of the gas phase type containing the C element include Si₂C, SiC₂, SiC, and C. In other words, a SiC-based gas is present in the main container 30.

Note that, as a material of the main container 30, GaN, AlN, InN, ZnS, ZnSe, CdTe, GaP, GaAs, InP, InAs, InSb, or the like can be adopted. By adopting the main container 30 made of the same material as the epitaxial layer 20 to be grown, a desired epitaxial layer 20 can be obtained.

The dopant and dopant concentration of the main container 30 can be selected to suit the desired dopant and dopant concentration of the epitaxial layer 20. By adopting polycrystalline SiC having a dopant concentration lower than that of the bulk layer 10 as the material of main container 30, the epitaxial layer 20 having a dopant concentration lower than that of the bulk layer 10 can be grown.

Note that the structure can be adopted as long as the vapor pressure of the gas phase type containing the Si element and the gas phase type containing the C element is generated in the internal space during the heating treatment of the main container 30. For example, a configuration in which the polycrystalline SiC is exposed on a part of the inner surface, a configuration in which the polycrystalline SiC is separately disposed in the main container 30, and the like can be shown.

As illustrated in Figs. 2 and 3, the main container 30 is a fitting container including an upper container 31 and a lower container 32 that can be fitted to each other. A minute gap 33 is formed in a fitting portion between the upper container 31 and the lower container 32, and inside of the main container 30 is configured to be able to be exhausted (evacuated) from the gap 33. In a case where it is desired to perform heating under the SiC-Si equilibrium vapor pressure environment, a Si vapor supply source 34 is disposed and heated as illustrated in Fig. 3. Examples of the Si vapor supply source 34 include solid Si (a Si pellet such as a single crystal Si piece or Si powder) and a Si compound.

The growth step S10 is a step of transporting Si atoms and C atoms of the main container 30 to a surface of the bulk layer 10 using a temperature difference provided between the bulk layer 10 and the main container 30 as a driving force. In other words, at least a part (for example, a top surface of the upper container 31) of the main container 30 becomes higher in temperature than the bulk layer 10 due to the temperature gradient formed by a heating furnace, thereby generating the driving force for transporting the source to the bulk layer 10.

Specifically, when the temperature of the surface of the bulk layer 10 is compared with the temperature of the top surface of the upper container 31 facing the bulk layer 10, heating is performed such that the temperature on a bulk layer 10 side is low and the temperature on an upper container 31 side is high. As described above, by forming a space provided with a temperature difference between the bulk layer 10 and the upper container 31 in the main container 30, Si atoms and C atoms of the upper container 31 can be transported to the bulk layer 10 using the temperature difference as a driving force.

### (Refractory material container 40)

The refractory material container 40 contains a refractory material. For example, C which is a general-purpose heat-resistant member, W, Re, Os, Ta, and Mo which are refractory metals, Ta₉C₈, HfC, TaC, NbC, ZrC, Ta₂C, TiC, WC, and MoC which are carbides, HfN, TaN, BN, Ta₂N, ZrN, and TiN which are nitrides, HfB₂, TaB₂, ZrB₂, NB₂, TiB₂, polycrystalline SiC which are borides, or a material similar to the main container 30 can be exemplified.

Similarly to the main container 30, the refractory material container 40 is a fitting container including an upper container 41 and a lower container 42 that can be fitted to each other, and is configured to be capable of accommodating the main container 30. A minute gap 43 is formed in a fitting portion between the upper container 41 and the lower container 42, and inside of refractory material container 40 can be exhausted (evacuated) from the gap 43.

The refractory material container 40 includes a vapor supply source that generates therein a vapor pressure of a vapor phase species containing an element of a semiconductor material to be grown. For example, in a case where the epitaxial layer 20 of silicon carbide is grown, the Si vapor supply source 44 capable of supplying vapor pressure of vapor phase species containing Si element into the refractory material container 40 is provided. The Si vapor supply source 44 may be configured to generate Si vapor in the refractory material container 40 during the heat treatment, and examples thereof include the solid Si (the Si pellet such as the single crystal Si piece or Si powder) and the Si compound. For example, a layer obtained by silicidation of a refractory material may be provided inside the above-described refractory material container 40.

In addition, any configuration can be adopted as long as the vapor pressure of the vapor phase species containing the Si element is formed in the refractory material container 40 during the heat treatment.

### <Quantification step S20>

The quantification step S20 includes a first measurement step S21 of measuring the concentration of dopant of the epitaxial layer 20, a second measurement step S22 of measuring the carrier concentration of the epitaxial layer 20, and a calculation step S23 of calculating the activation rate of dopant of the epitaxial layer 20 based on the measurement results of the first measurement step S21 and the second measurement step S22.

The first measurement step S21 is a step of measuring a total amount of the dopant doped in the epitaxial layer 20. As a measurement method adopted in the first measurement step S21, secondary ion mass spectrometry can be exemplified. In addition, any method capable of measuring the total amount of the dopant of the epitaxial layer 20 can be adopted.

The second measurement step S22 is a step of measuring the amount of dopant activated in the epitaxial layer 20. Examples of the measurement method adopted in the second measurement step S22 can include Raman spectroscopy and capacity (C-V) measurement. In addition, any method capable of measuring the carrier concentration of the epitaxial layer 20 can be adopted.

The calculation step S23 is a step of calculating the activation rate of dopant indicating how much the dopant is activated in the epitaxial layer 20. The activation rate of dopant can be calculated by dividing the amount of the activated dopant of the epitaxial layer 20 obtained in the second measurement step S22 by the total amount of the dopant of the epitaxial layer 20 obtained in the first measurement step S21 (activation rate of dopant = amount of activated dopant/total amount of dopant).

According to the method for improving the activation rate of dopant according to the embodiment, by including the growth step S10 of growing the epitaxial layer 20 under the equilibrium vapor pressure environment, the activation rate of dopant of the epitaxial layer 20 can be improved. As described above, improvement of the activation rate of dopant can contribute to reduction of the on-resistance of the semiconductor device.

According to the method for improving the activation rate of dopant according to the embodiment, by including the growth step S10 of growing the epitaxial layer 20 under the equilibrium vapor pressure environment, it is possible to suppress the variation in activation rate of dopant of the epitaxial layer 20. By suppressing variations in the activation rate of dopant in this manner, variations in threshold voltage and on-resistance of the semiconductor device can be suppressed.

The growth step S10 according to the present invention may include a step of growing at least one epitaxial layer 20 under the equilibrium vapor pressure environment. Therefore, in a case where the two epitaxial layers 20 are grown under different growth conditions, the activation rate of dopant may be improved by growing any one layer under the equilibrium vapor pressure environment.

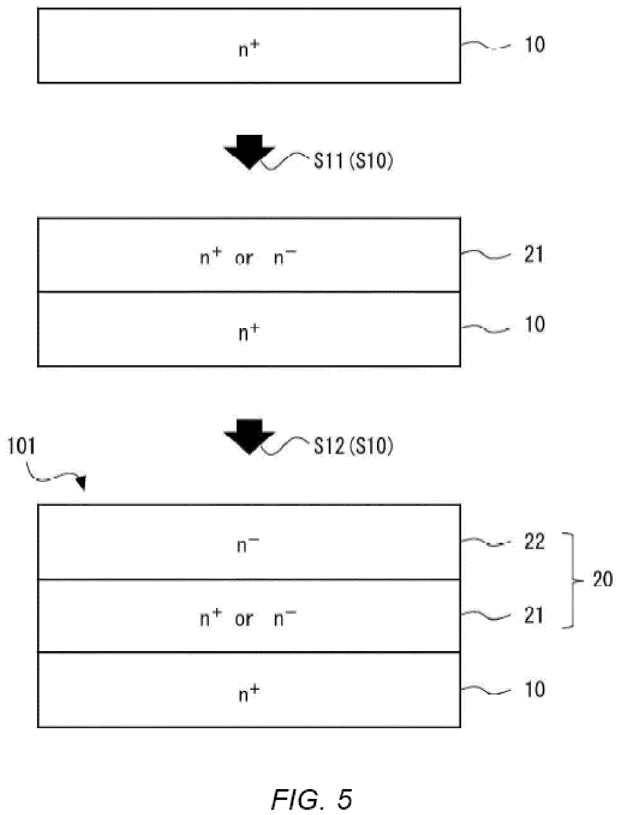

Fig. 5 is the explanatory view for explaining the another embodiment of the method for improving the activation rate of dopant. Constituent elements that are basically the same as the constituent elements described in the previous embodiments are denoted by the same reference numerals, and the description thereof will be simplified.

The method for improving the activation rate of dopant according to another embodiment includes the growth step S10 of growing the epitaxial layer 20 on the bulk layer 10, and the growth step S10 includes a first growth step S11 of growing an n⁺ type or n⁻ type first epitaxial layer 21 under the equilibrium vapor pressure environment, and a second growth step S12 of growing the n⁻ type second epitaxial layer 22 having a dopant concentration lower than that of the bulk layer 10 on the first epitaxial layer 21.

In other words, as illustrated in Fig. 5, the epitaxial layer 20 according to another embodiment may include the bulk layer 10, the first epitaxial layer 21 having a higher activation rate of dopant than the bulk layer 10, and the second epitaxial layer 22 having a lower dopant concentration than the bulk layer 10 grown on the first epitaxial layer 21.

In the first growth step S11, the n⁺ type first epitaxial layer 21 having a dopant concentration equivalent to that of the n⁺ type bulk layer 10 may be grown, or the n⁻ type first epitaxial layer 21 having a dopant concentration lower than that of the bulk layer 10 may be grown. In other words, the concentration of dopant of the first epitaxial layer 21 is preferably 1 × 10¹⁷ cm⁻³ or less, more preferably 1 × 10¹⁶ cm⁻³ or less, still more preferably 1 × 10¹⁵ cm⁻³ or less, and is preferably 1 × 10¹⁷ cm⁻³ or more, more preferably 1 × 10¹⁸ cm⁻³ or more, and still more preferably 1 × 10¹⁹ cm⁻³ or more. As a growth method of the first growth step S11, a method similar to that of the previous embodiment can be adopted.

The first epitaxial layer 21 is a layer having a higher activation rate of dopant than that of the bulk layer 10. The activation rate of dopant of the first epitaxial layer 21 is preferably 33% or more, more preferably 40% or more, further preferably 50% or more, further preferably 60% or more, further preferably 66% or more, further preferably 70% or more, further preferably 80% or more, and still further preferably 90% or more.

It is preferable that the variation in activation rate of dopant is suppressed in the plane of the first epitaxial layer 21. Specifically, the standard deviation of the carrier concentration measured at the plurality of points in the plane of the first epitaxial layer 21 is preferably 1.0 × 10¹⁷ cm⁻³ or less, more preferably 5.0 × 10¹⁶ cm⁻³ or less, further preferably 3.0 × 10¹⁶ cm⁻³ or less, further preferably 2.0 × 10¹⁶ cm⁻³ or less, further preferably 1.0 × 10¹⁶ cm⁻³ or less, further preferably 5.0 × 10¹⁵ cm⁻³ or less, and still further preferably 3.0 × 10¹⁵ cm⁻³ or less.

The value of the variation coefficient (standard deviation/average value) of the carrier concentration in the plane of the first epitaxial layer 21 is preferably 0.05 or less, more preferably 0.04 or less, further preferably 0.04 or less, further preferably 0.02 or less, and still further preferably 0.01 or less. As described above, since the variation in carrier concentration is suppressed to be extremely small, it is suggested that the variation in activation rate of dopant is suppressed.

In the second growth step S12, a growth method different from that in the previous first growth step S11 can be adopted. For example, a known film forming method such as a physical vapor deposition method (PVD method) or a chemical vapor deposition method (CVD method) may be adopted.

The concentration of dopant of the second epitaxial layer 22 is preferably lower than 1 × 10¹⁷ cm⁻³, more preferably 1 × 10¹⁶ cm⁻³ or less, and still more preferably 1 × 10¹⁵ cm⁻³ or less.

According to another embodiment, the first epitaxial layer 21 having a higher activation rate of dopant than that of the bulk layer 10 can be formed on the bulk layer 10. By forming the first epitaxial layer 21, it is possible to contribute to the reduction of on-resistance by removing at least a part of the bulk layer 10 when the semiconductor device is manufactured.

### <<Semiconductor substrate>>

The semiconductor substrate according to the present invention is substrates 100 and 101 manufactured using the above-described method for improving the activation rate of dopant of the epitaxial layer, and includes the epitaxial layer 20 having a higher activation rate of dopant than that of the bulk layer 10. In a case where the entire bulk layer 10 is removed in a process of manufacturing the substrate, the semiconductor substrate is constituted by the epitaxial layer 20.

As illustrated in Fig. 1, the semiconductor substrate 100 according to the embodiment includes one epitaxial layer 20 having a higher activation rate of dopant than that of the bulk layer 10. The activation rate of dopant of a commercially available substrate (the bulk layer 10) is 33%. Therefore, the activation rate of dopant of the epitaxial layer 20 is preferably 33% or more, more preferably 40% or more, further preferably 50% or more, further preferably 60% or more, further preferably 66% or more, further preferably 70% or more, further preferably 80% or more, and still further preferably 90% or more.

It is preferable that the variation in activation rate of dopant is suppressed in the plane of the epitaxial layer 20. Specifically, a standard deviation of the carrier concentration measured at a plurality of points in a plane of the epitaxial layer 20 is preferably 1.0 × 10¹⁷ cm⁻³ or less, more preferably 5.0 × 10¹⁶ cm⁻³ or less, further preferably 3.0 × 10¹⁶ cm⁻³ or less, further preferably 2.0 × 10¹⁶ cm⁻³ or less, further preferably 1.0 × 10¹⁶ cm⁻³ or less, further preferably 5.0 × 10¹⁵ cm⁻³ or less, and still further preferably 3.0 × 10¹⁵ cm⁻³ or less.

A value of a variation coefficient (standard deviation/average value) of the carrier concentration in the plane of the epitaxial layer 20 is preferably 0.05 or less, more preferably 0.04 or less, more preferably 0.04 or less, more preferably 0.02 or less, and still more preferably 0.01 or less. As described above, since the variation in carrier concentration is suppressed to be extremely small, it is suggested that the variation in activation rate of dopant is suppressed.

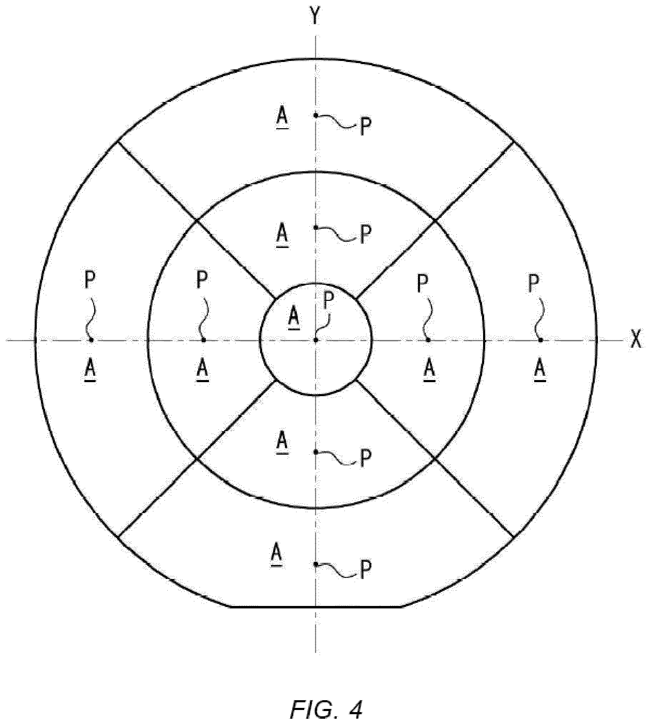

As illustrated in Fig. 4, an average value and the standard deviation of the carrier concentration are obtained by measuring the carrier concentration of the epitaxial layer 20 at a plurality of measurement points P and calculating the average value and the standard deviation from the results of the plurality of measurement points P. In Fig. 4, an entire region of the epitaxial layer 20 is divided into nine sections to set an arbitrary area A, and the measurement points P are arranged for each arbitrary area A.

The concentration of dopant of the epitaxial layer 20 is preferably lower than 1 × 10¹⁷ cm⁻³, more preferably 1 × 10¹⁶ cm⁻³ or less, and still more preferably 1 × 10¹⁵ cm⁻³ or less.

A diameter of the bulk layer 10 is preferably 4 inches or more, more preferably 6 inches or more, and still more preferably 8 inches or more.

As illustrated in Fig. 5, the substrate 101 according to another embodiment includes the first epitaxial layer 21 having a higher activation rate of dopant than that of the bulk layer 10 and the second epitaxial layer 22 having a lower dopant concentration than that of the bulk layer 10.

The first epitaxial layer 21 may be the n+ type epitaxial layer having a dopant concentration equivalent to that of the bulk layer 10, or may be the n- type epitaxial layer having a dopant concentration lower than that of the bulk layer 10. In other words, the concentration of dopant of the first epitaxial layer 21 is preferably 1 × 10¹⁷ cm⁻³ or less, more preferably 1 × 10¹⁶ cm⁻³ or less, still more preferably 1 × 10¹⁵ cm⁻³ or less, and is preferably 1 × 10¹⁷ cm⁻³ or more, more preferably 1 × 10¹⁸ cm⁻³ or more, and still more preferably 1 × 10¹⁹ cm⁻³ or more.

The activation rate of dopant of the first epitaxial layer 21 is preferably 33% or more, more preferably 40% or more, further preferably 50% or more, further preferably 60% or more, further preferably 66% or more, further preferably 70% or more, further preferably 80% or more, and still further preferably 90% or more.

It is preferable that the variation in activation rate of dopant is suppressed in the plane of the first epitaxial layer 21. Specifically, the standard deviation of the carrier concentration measured at the plurality of points in the plane of the first epitaxial layer 21 is preferably 1.0 × 10¹⁷ cm⁻³ or less, more preferably 5.0 × 10¹⁶ cm⁻³ or less, further preferably 3.0 × 10¹⁶ cm⁻³ or less, further preferably 2.0 × 10¹⁶ cm⁻³ or less, further preferably 1.0 × 10¹⁶ cm⁻³ or less, further preferably 5.0 × 10¹⁵ cm⁻³ or less, and still further preferably 3.0 × 10¹⁵ cm⁻³ or less.

The value of the variation coefficient (standard deviation/average value) of the carrier concentration in the plane of the first epitaxial layer 21 is preferably 0.05 or less, more preferably 0.04 or less, further preferably 0.03 or less, further preferably 0.02 or less, and still more preferably 0.01 or less. As described above, since the variation in carrier concentration is suppressed to be extremely small, it is suggested that the variation in activation rate of dopant is suppressed.

The concentration of dopant of the second epitaxial layer 22 is preferably lower than 1 × 10¹⁷ cm⁻³, more preferably 1 × 10¹⁶ cm⁻³ or less, and still more preferably 1 × 10¹⁵ cm⁻³ or less.

A diameter of the bulk layer 10 is preferably 4 inches or more, more preferably 6 inches or more, and still more preferably 8 inches or more.

### <<Method of manufacturing semiconductor device>>

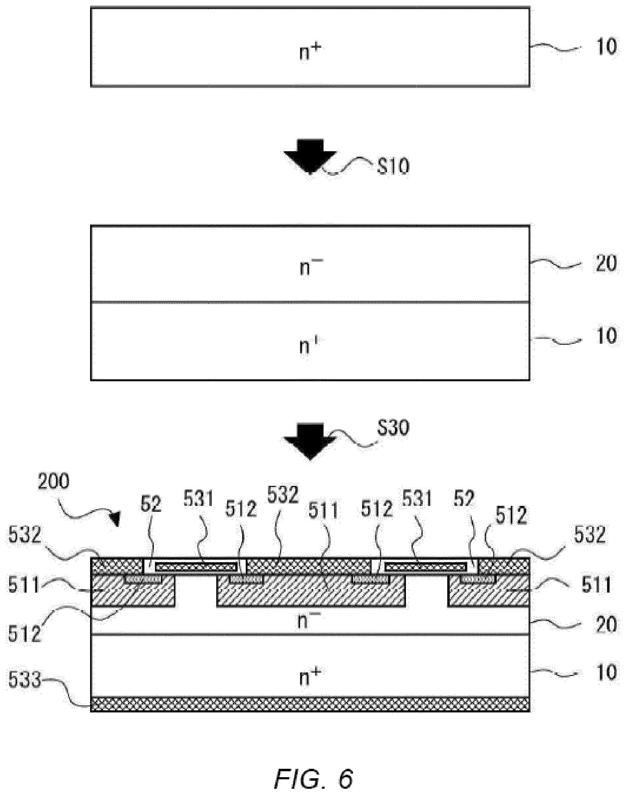

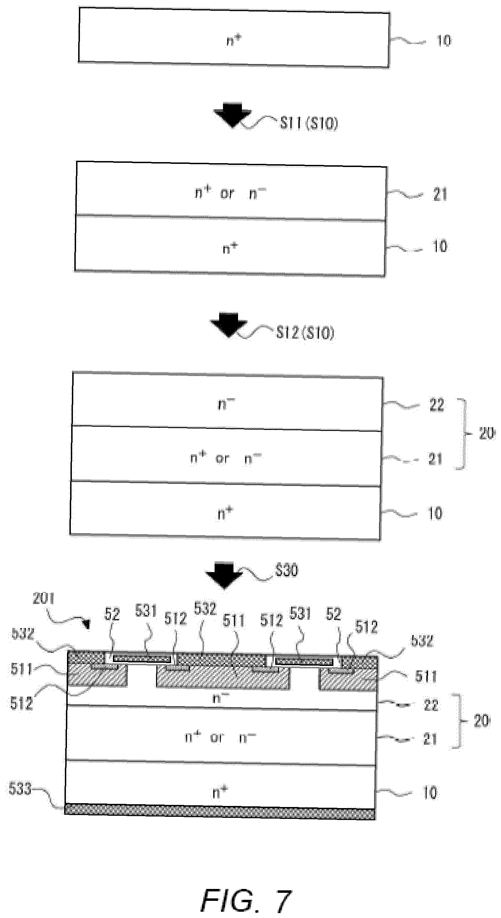

Fig. 6 is the explanatory view for explaining the method of manufacturing the semiconductor device according to the embodiment. Fig. 7 is the explanatory view for explaining the method of manufacturing the semiconductor device of silicon carbide according to the another embodiment. Constituent elements that are basically the same as the constituent elements described in the previous embodiments are denoted by the same reference numerals, and the description thereof will be simplified.

As illustrated in Figs. 6 and 7, the methods of manufacturing the semiconductor device of silicon carbide according to the embodiment and another embodiment include the growth step S10 of growing the epitaxial layer 20 having a dopant on the bulk layer 10 under the equilibrium vapor pressure environment, and a device formation step S30 of forming a device region 50 in at least a part of a substrate having the epitaxial layer 20.

The device region 50 is a structure necessary for functioning as a semiconductor device, and includes at least a doping region 51, an insulating film 52, and an electrode 53.

### <Device formation step S30>

The device formation step S30 includes, for example, a patterning step S31 of forming a circuit pattern on a substrate having the epitaxial layer 20, a doping step S32 of introducing the doping region 51 into the substrate using this circuit pattern, an insulating film formation step S33 of forming the insulating film 52, and an electrode formation step S34 of forming the electrode 53.

The patterning step S31 can includes, by way of example, a resist application step of applying a photoresist, an exposure step of exposing the photoresist through a photomask, a development step of developing the exposed photoresist, and a selective etching step of etching the exposed surface below the photoresist. Through these steps, the circuit pattern can be formed on the substrate.

The doping step S32 may include, for example, an ion implantation step of irradiating the substrate with dopant ions that are ionized dopant atoms, and an activation step of performing an activation treatment by heat treating the substrate irradiated with the dopant ions.

This step is a step of forming the doping region 51 by repeating the patterning step S31 and the doping step S32. The doping region 51 includes, for example, one or more of an n-type or p-type well region 511, an n-type or p-type contact region 512, an n-type or p-type drift region, a body region, a base region, a source region, a collector region, a field stop region, a pillar region, a buffer region, a recombination promoting region, or an embedded region.

The insulating film formation step S33 is a step of forming the insulating film 52. As an example, the insulating film 52 includes one or more of a gate insulating film, an interlayer insulating film for element isolation, and a cap layer for adjusting a flat band voltage or the like in a gate electrode.

The electrode formation step S34 is a step of forming the electrode 53 for functioning as a semiconductor device. Examples of the electrode 53 include one or more of a gate electrode 531, a source electrode 532, a drain electrode 533, a base electrode, an emitter electrode, a collector electrode, an anode electrode, a cathode electrode, an ohmic electrode, and a Schottky electrode.

Further, the device formation step S30 may further include a removal step S35 of removing at least a part of the bulk layer 10 from a back surface side. As described above, by removing a part or the whole of the bulk layer 10, it is possible to reduce a thickness of the bulk layer 10 which is a conductive layer and contribute to the reduction of on-resistance. The removal step S35 can be adopted as long as it is a method for reducing the thickness of the bulk layer 10, and a known grinding method, polishing method, etching method, and the like can be exemplified.

### <<Semiconductor device>>

A semiconductor device according to the present invention is semiconductor devices 200 and 201 manufactured using the method for improving the activation rate of dopant of the epitaxial layer described above, and includes an epitaxial layer (the epitaxial layer 20 or the first epitaxial layer 21) in which the activation rate of dopant is improved, and the device region 50.

The epitaxial layer (the epitaxial layer 20 or the first epitaxial layer 21) has a higher activation rate of dopant than the bulk layer 10. The activation rate of dopant of a commercially available substrate (the bulk layer 10) is 33%. Therefore, the activation rate of dopant of the epitaxial layer 20 or the first epitaxial layer 21 is preferably 33% or more, more preferably 40% or more, further preferably 50% or more, further preferably 60% or more, further preferably 66% or more, further preferably 70% or more, further preferably 80% or more, and still further preferably 90% or more.

It is preferable that the variation in activation rate of dopant is suppressed in the plane of the epitaxial layer. Specifically, the standard deviation of the carrier concentration measured at the plurality of points in the plane of the epitaxial layer is preferably 1.0 × 10¹⁷ cm⁻³ or less, more preferably 5.0 × 10¹⁶ cm⁻³ or less, further preferably 3.0 × 10¹⁶ cm⁻³ or less, further preferably 2.0 × 10¹⁶ cm⁻³ or less, further preferably 1.0 × 10¹⁶ cm⁻³ or less, further preferably 5.0 × 10¹⁵ cm⁻³ or less, and still further preferably 3.0 × 10¹⁵ cm⁻³ or less.

The value of the variation coefficient (standard deviation/average value) of the carrier concentration in the plane of the epitaxial layer is preferably 0.05 or less, more preferably 0.04 or less, further preferably 0.03 or less, further preferably 0.02 or less, and still further preferably 0.01 or less. As described above, in a case where the variation in carrier concentration is suppressed to an extremely low level, it is suggested that the variation in activation rate of dopant is suppressed.

The semiconductor devices 200 and 201 according to these embodiments each have an epitaxial layer (the epitaxial layer 20 or the first epitaxial layer 21) with a high activation rate of dopant, and thus contribute to the reduction of on-resistance.

Since the semiconductor devices 200 and 201 according to these embodiments include the epitaxial layers (the epitaxial layer 20 or the first epitaxial layer 21) in which the variation in activation rate of dopant is small, it is possible to suppress the current concentration to a specific location that may cause breakdown of the semiconductor device.

The semiconductor device includes, for example, a Schottky barrier diode, a junction barrier Schottky diode, a thyristor, a bipolar junction transistor, and a PiN diode.

### Examples

Hereinafter, the present invention will be described more specifically based on the examples. The present invention is not limited to the following contents.

An apparatus used in the following examples is an apparatus described in Patent Literature 2, and used one that includes the main container 30, the refractory material container 40, and the heating furnace that accommodates the main container 30 and the refractory material container 40 and is capable of heating to form the temperature gradient. A device described in Patent Literature 3 may be used.

The growth step S10 of growing the epitaxial layer 20 under the equilibrium vapor pressure environment was performed on a silicon carbide substrate inclined 4 degrees in the <11-20> direction of a 6-inch diameter. Thereafter, the quantification step S20 of quantifying the activation rate of dopant was performed on the grown epitaxial layer 20.

### (Growth step S10)

In the growth step S10, the silicon carbide substrate was accommodated in the main container 30, and the main container 30 was accommodated in the refractory material container 40 and heated at 1900°C using the heating furnace.

As the main container 30, a container made of polycrystalline SiC was used. The atomic ratio Si/C in the main container 30 in which the silicon carbide substrate was disposed was 1. Specifically, since the silicon carbide substrate satisfying the stoichiometric ratio 1: 1 was disposed in the main container 30 made of polycrystalline SiC satisfying the stoichiometric ratio 1: 1, the atomic ratio Si/C in the main container 30 was 1. As described above, the epitaxial layer 20 was grown in the SiC-C equilibrium vapor pressure environment by heating the main container 30 in which the atomic ratio Si/C in the container was 1. In the embodiment, the epitaxial layer 20 is grown in the SiC-C equilibrium vapor pressure environment, but the same effect can be expected even in a case where the SiC-Si equilibrium vapor pressure environment is adopted.

As the refractory material container 40, a container made of TaC having a tantalum silicide layer on an inner side was used. In other words, the Si vapor pressure environment in the refractory material container 40 was formed by heating the tantalum silicide layer and supplying Si vapor into the container.

### (Quantification step S20)

The first measurement step S21 of measuring the total amount of the dopant doped in the epitaxial layer 20 was performed on the epitaxial layer 20 grown in the growth step S10. As a result of measuring the total amount of the dopant using the secondary ion mass spectrometry, the total amount of the dopant in a measurement range of the epitaxial layer 20 was 4.0 × 10¹⁸ cm⁻³.

Next, the epitaxial layer 20 grown in the growth step S10 is subjected to the second measurement step S22 of measuring the amount of dopant activated in the epitaxial layer 20. As a result of measuring the carrier concentration using the Raman spectroscopy, the amount of the activated dopant in the measurement range of the epitaxial layer 20 was 2.5 × 10¹⁸ cm⁻³.

Finally, the activation rate of dopant in the measurement range of the epitaxial layer 20 was calculated using the results obtained in the first measurement step S21 and the second measurement step S22. As a result, the activation rate of dopant was 2.5 × 10¹⁸/4.0 × 10¹⁸ × 100 = 62.5%.

The activation rate of dopant obtained by performing the same quantification step S20 on the bulk layer 10 was 33%. Therefore, it can be seen that the activation rate of dopant of the epitaxial layer 20 of the example is higher than that of the bulk layer 10.

According to the example, it is found that the epitaxial layer 20 in which the activation rate of dopant is 33% or more can be obtained by including the growth step of growing under the equilibrium vapor pressure environment. In particular, according to this example, the epitaxial layer 20 having an activation rate of dopant of 60% or more was obtained. Therefore, a semiconductor device manufactured using a semiconductor substrate having the epitaxial layer 20 grown by the method of the present invention can reduce the on-resistance.

For the epitaxial layer 20 of this example, the entire region of the epitaxial layer 20 was divided into nine sections to set an arbitrary area A (see Fig. 4), measurement points P were arranged for each the arbitrary area A, and the carrier concentration was measured. As a result, the standard deviation of the carrier concentration was 1.36 × 10¹⁶ cm⁻³. The value of the variation coefficient (standard deviation/average value) of the carrier concentration was 0.0147.

The standard deviation of the carrier concentration obtained by performing the same measurement on the bulk layer 10 was 1.51 × 10¹⁷ cm⁻³. The value of the variation coefficient (standard deviation/average value) of the carrier concentration of the bulk layer 10 was 0.0592. Therefore, it is suggested that the activation rate of dopant of the epitaxial layer 20 of the example varies less than that of the bulk layer 10.

According to this example, by including the growth step of growing under the equilibrium vapor pressure environment, it is found that the epitaxial layer 20 having extremely little in-plane variation in which the standard deviation of the carrier concentration is 1.0 × 10¹⁷ cm⁻³ or less and the value of the variation coefficient (standard deviation/average value) of the carrier concentration is 0.02 or less can be obtained.

As described above, a semiconductor device manufactured using a semiconductor substrate having the epitaxial layer 20 grown by the method of the present invention can suppress the current concentration at a specific location that can cause the breakdown of the semiconductor device.

### Reference Signs List

- 100, 101: Semiconductor substrate
- 200, 201: Semiconductor device
- 10: Bulk layer
- 20: Epitaxial layer
- 21: First epitaxial layer
- 22: Second epitaxial layer
- 30: Main container
- 31: Upper container
- 32: Lower container
- 33: Gap
- 34: Si vapor supply source
- 40: Refractory material container
- 41: Upper container
- 42: Lower container
- 43: Gap
- 44: Si vapor supply source
- 50: Device region
- 51: Doping region
- 52: Insulating film
- 53: Electrode
- S10: Growth step
- S20: Quantification step
- S21: First measurement step
- S22: Second measurement step
- S23: Calculation step
- S30: Device formation step

## Claims

1. A method for improving an activation rate of dopant of an epitaxial layer, comprising a growth step of growing the epitaxial layer on a bulk layer under an equilibrium vapor pressure environment.

2. The method according to claim 1, wherein the growth step is a step of growing the epitaxial layer having a higher activation rate of dopant than that of the bulk layer.

3. The method according to claim 1 or 2, wherein the growth step is a step of crystal-growing the epitaxial layer in which the activation rate of dopant is 33% or more.

4. The method according to any one of claims 1 to 3, comprising a quantification step of quantifying the activation rate of dopant of the epitaxial layer.

5. The method according to claim 4, wherein
the quantification step includes:
a first measurement step of measuring a concentration of dopant in the epitaxial layer; and
a second measurement step of measuring a carrier concentration of the epitaxial layer; and
a calculation step of calculating the activation rate of dopant of the epitaxial layer based on measurement results of the first measurement step and the second measurement step.

6. The method according to any one of claims 1 to 5, wherein the growth step is growing the epitaxial layer on a bulk layer having a diameter of at least 4 inches or more.

7. A method of manufacturing a semiconductor substrate using the method according to any one of claims 1 to 6.

8. A semiconductor substrate manufactured by the method according to claim 7, wherein
the activation rate of dopant in the epitaxial layer is higher than that of the bulk layer.

9. A semiconductor substrate comprising an epitaxial layer grown on top of a bulk layer, wherein
the epitaxial layer has a higher activation rate of dopant than that of the bulk layer.

10. The substrate according to claim 9, wherein the epitaxial layer has the activation rate of dopant of 33% or more.

11. The substrate according to any one of claims 8 to 10, wherein the substrate has a diameter of at least 4 inches or more.

12. A method of manufacturing a semiconductor device using a semiconductor substrate having an epitaxial layer grown by the method according to any one of claims 1 to 6, the method comprising:
a device formation step of forming a device region in at least a part of the substrate.

13. The method according to claim 12, further comprising a removal step of removing at least a portion of the bulk layer.

14. A semiconductor device manufactured by the method according to claim 12 or 13, wherein
the activation rate of dopant in the epitaxial layer is higher than that of the bulk layer.

15. A semiconductor device comprising an epitaxial layer having a higher activation rate of dopant than a bulk layer.

16. The semiconductor device according to claim 14 or 15, wherein the epitaxial layer has the activation rate of dopant of 33% or more.
